(19) Europäisches Patentamt / European Patent Office / Office européen des brevets

(11) **EP 3 361 841 B1**

(12) **EUROPEAN PATENT SPECIFICATION**

(45) Date of publication and mention
of the grant of the patent:
**01.07.2020 Bulletin 2020/27**

(51) Int Cl.:
*H05K 3/46* *(2006.01)*        *H01L 23/12* *(2006.01)*
*H01L 21/48* *(2006.01)*

(21) Application number: **16853478.2**

(22) Date of filing: **29.09.2016**

(86) International application number:
**PCT/JP2016/078866**

(87) International publication number:
**WO 2017/061324 (13.04.2017 Gazette 2017/15)**

(54) **METHOD FOR MANUFACTURING MULTILAYER CERAMIC SUBSTRATE**

VERFAHREN ZUR HERSTELLUNG EINES MEHRSCHICHTIGEN KERAMIKSUBSTRATS

PROCÉDÉ DE FABRICATION DE SUBSTRAT CÉRAMIQUE MULTICOUCHE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **09.10.2015 JP 2015200751**

(43) Date of publication of application:
**15.08.2018 Bulletin 2018/33**

(73) Proprietor: **Hitachi Metals, Ltd.
Tokyo 108-8224 (JP)**

(72) Inventors:
• **MASUKAWA, Junichi
Minato-ku, Tokyo 108-8224 (JP)**
• **IKEDA, Hatsuo
Minato-ku, Tokyo 108-8224 (JP)**

(74) Representative: **Fleuchaus, Michael A. et al
Fleuchaus & Gallo Partnerschaft mbB
Patentanwälte
Steinerstraße 15/Haus A
81369 München (DE)**

(56) References cited:
EP-A2- 1 720 203        WO-A1-2014/083974
JP-A- H06 215 982        JP-A- H10 200 260
JP-A- 2001 358 247        JP-A- 2004 182 836
JP-A- 2009 188 096        JP-A- 2010 087 521
US-A1- 2011 045 242

**Description**

## TECHNICAL FIELD

The present invention relates to a method of producing a multi-layer ceramic substrate having a cavity.

## BACKGROUND ART

Multi-layer ceramic substrates have been widely used as wiring substrates for use in various electronic devices such as communication devices. Using a multi-layer ceramic substrate, it is possible to incorporate passive elements, such as capacitors, coils and transmission paths, into the substrate and implement electronic components on the surface of the substrate, thus realizing a small module. Moreover, in recent years, a cavity is provided in a multi-layer ceramic substrate and a semiconductor IC is accommodated in the cavity so as to achieve a low profile of the module as a whole and to highly integrate and combine functions together.

Such a multi-layer ceramic substrate with a cavity is commonly produced by laminating and pressure-bonding together a ceramic green sheet having an opening corresponding to the cavity and a ceramic green sheet having no opening, and then sintering the ceramic green sheets. However, a ceramic green sheet having an opening is likely to deform when pressure-bonded.

In view of this, Patent Document No. 1 discloses a method of producing a multi-layer ceramic substrate with a cavity, wherein a ceramic green sheet laminate is produced by providing a peel-off layer sandwiched at a position to be the bottom of the cavity, making a slit that reaches the peel-off layer from one primary surface of the laminate before or after the preliminary sintering (debindering process), removing a portion of the green sheet that corresponds to the cavity, and then sintering the laminate.

Patent Document No. 2 discloses a method of producing a multi-layer ceramic substrate with a cavity, wherein a ceramic green sheet laminate is produced by providing a burn-out material layer sandwiched at a position to be the bottom of the cavity, and grooving the laminate from one primary surface thereof before or after co-firing the laminate, so that the burn-out material layer is burnt out in the co-firing process, thus producing an internal space, whereby the cavity portion can be removed.

JP 2009188096 A discloses a method for producing a ceramic laminated circuit board which can be used when projections or recesses are formed on the ceramic laminated board. Furthermore, JP6215982 A discloses a composite thick film electronic component with a foamed layer.

## CITATION LIST

### PATENT LITERATURE

[Patent Document No. 1] Japanese Laid-Open Patent Publication No. 2001-358247
[Patent Document No. 2] Japanese Laid-Open Patent Publication No. 2003-273267

## SUMMARY OF INVENTION

### TECHNICAL PROBLEM

However, as a result of a study by the present inventor, it was found that it may not be easy in some cases to form a cavity by the methods of Patent Document Nos. 1 and 2. It is an object of the present invention to provide a method of producing a multi-layer ceramic substrate which has a good mass productivity and with which it is possible to easily form a cavity.

### SOLUTION TO PROBLEM

A method of producing a multi-layer ceramic substrate of the present invention includes the steps of: (A) preparing a first ceramic green sheet with a thermal expansion layer arranged thereon, and at least one second ceramic green sheet with no thermal expansion layer arranged thereon, the thermal expansion layer being formed and patterned on the first ceramic green sheet by a printing method with use of a thermal expansion layer paste; (B) laminating the first and second ceramic green sheets with the thermal expansion layer sandwiched therebetween, thereby obtaining a green sheet laminate; (C) pressure-bonding together the first ceramic green sheet and the at least one second ceramic green sheet of the green sheet laminate; (D) heating and thereby expanding the thermal expansion layer at least in a thickness direction in the pressure-bonded green sheet laminate; (E) extracting a portion of the green sheet laminate that has been displaced by the expansion of the thermal expansion layer, thereby forming a cavity in the green sheet laminate; and (F) sintering the green sheet laminate with the cavity formed therein.

In the step (D), the thermal expansion layer may be held at a temperature higher than a temperature for pressure-bonding in the step (C).

The thermal expansion layer may include a thermal expansion material whose thickness increases by a factor of 2 or more by being heated.

The thermal expansion layer may be a layer of a paste including thermally-expansive microcapsules made of a thermoplastic resin that encapsulate a hydrocarbon that is in liquid form at normal temperature.

The method may further include, between the step (C) and the step (D), a step of forming, in the green sheet laminate, a groove that has a depth of the cavity of the green sheet laminate and defines an outline of the cavity.

The thermal expansion layer may be removed in the step (E).

In the step (A), a third ceramic green sheet with another thermal expansion layer arranged thereon may be prepared in a region different from the first ceramic green sheet; in the step (B), the first to third ceramic green sheets may be laminated together so that the thermal expansion layers are sandwiched therebetween, thereby obtaining the green sheet laminate; in the step (D), the other thermal expansion layer may be heated to be expanded at least in the thickness direction; and in the step (E), a portion of the green sheet laminate that has been displaced by the expansion of the other thermal expansion layer may be extracted.

The method may further include, between the step (E) and the step (F), a step (G) of removing a binder from the green sheet laminate.

In the step (D), the thermal expansion layer may be held at a temperature that is higher than a temperature for pressure-bonding in the step (C) and lower than a temperature for binder removing in the step (G).

In the step (A), at least one of the first ceramic green sheet and the second ceramic green sheet may include a pattern to be internal wiring, an inductor, a condenser, a stripline or an internal resistor.

In the step (A), the first ceramic green sheet may further include a conductor pattern located between the thermal expansion layer and the first ceramic green sheet.

In the step (A), at least one of the first ceramic green sheet and the second ceramic green sheet may further include a via hole and a conductive paste that fills the via hole.

## ADVANTAGEOUS EFFECTS OF INVENTION

According to the present invention, there is provided a method of producing a multi-layer ceramic substrate which has a good mass productivity and with which it is easy to extract a portion corresponding to the cavity.

## BRIEF DESCRIPTION OF DRAWINGS

[FIG. 1] (a) is a perspective view showing an example of a multi-layer ceramic substrate of the present embodiment, (b) is a cross-sectional view taken along line 1B-1B of (a), and (c) is a perspective view showing an example of a multi-layer ceramic substrate with a semiconductor IC chip mounted in the cavity.

[FIG. 2] A flow chart showing a method of producing a multi-layer ceramic substrate of the present embodiment.

[FIG. 3] (a) to (c) are process step cross-sectional views showing a method of producing a multi-layer ceramic substrate of the present embodiment.

[FIG. 4] (a) to (d) are process step cross-sectional views showing the method of producing a multi-layer ceramic substrate of the present embodiment.

[FIG. 5] (a) and (b) are schematic diagrams showing, on an enlarged scale, the vicinity of an end portion of a thermal expansion layer for illustrating the expansion of the thermal expansion layer and the separation of the portion to be the cavity.

[FIG. 6] (a) is a cross-sectional view showing another example of a multi-layer ceramic substrate of the present embodiment, and (b) is a cross-sectional view showing one step of a method of producing the multi-layer ceramic substrate of (a).

[FIG. 7] (a) is a cross-sectional view showing another example of a multi-layer ceramic substrate of the present embodiment, and (b) is a cross-sectional view showing one step of a method of prducing the multi-layer ceramic substrate of (a).

[FIG. 8] (a) is a cross-sectional view showing another example of a multi-layer ceramic substrate of the present embodiment, and (b) is a plan view of (a).

[FIG. **9**] A cross-sectional view showing one step of a method of prducing the multi-layer ceramic substrate shown in FIG. **8**.

[FIG. **10**] **(a)** is a cross-sectional view showing another example of a multi-layer ceramic substrate of the present embodiment, and **(b)** is a plan view of **(a)**.

[FIG. **11**] **(a)** is a cross-sectional view showing another example of a multi-layer ceramic substrate of the present embodiment, and **(b)** is a plan view of **(a)**.

[FIG. **12**] A graph showing the relationship between the temperature of the thermal expansion layer and the expansion factor for samples shown in Table 1.

[FIG. **13**] **(a)** and **(b)** are optical microscopic images, before and after the expansion of the thermal expansion layer, of a green sheet laminate of a sample produced by a method of producing a multi-layer ceramic substrate of the present embodiment.

## DESCRIPTION OF EMBODIMENTS

The present inventor made an in-depth study on the methods for manufacturing a multi-layer ceramic substrate disclosed in Patent Document Nos. 1 and 2. According to the methods of Patent Document Nos. 1 and 2, there is a need to form a slit or a groove reaching a peel-off layer or a burn-out layer in order to extract a portion of a green sheet corresponding to the cavity or a portion of a sinter corresponding to the cavity. It is difficult to separate the portion corresponding to the cavity unless the slit or groove is aligned with the position of the peel-off layer or burn-out layer and reliably extends to reach the peel-off layer or burn-out layer. Particularly, with the method of Patent Document No. 2, whether the portion corresponding to the cavity can be separated is known after the co-firing process, and it is therefore necessary to perform the manufacturing process up to the co-firing process even if it is a defective product.

According to the method of Patent Document No. 1, since the peel-off layer is made of a material such that the ceramic green sheet can be peeled off easily, a green sheet laminate with the peel-off layer interposed therein will have an insufficient adhesion between the peel-off layer and the ceramic green sheet. Therefore, the pressure-bonded green sheet laminate may have an insufficient form stability or a green sheet may be shitted when forming a slit. With such problems described above, it may be difficult in some cases to stably manufacture a multi-layer ceramic substrate, thereby posing problems particularly in view of mass productivity. In view of such problems, the present inventor arrived at a novel method of producing a multi-layer ceramic substrate. One embodiment of a multi-layer ceramic substrate and a method of prducing a multi-layer ceramic substrate of the present invention will now be described in detail. Note that a green sheet laminate as used in the description below is what is obtained by laminating first and second ceramic green sheets together, and every state from lamination until sintering is defined as a green sheet laminate, irrespective of the order and number of the sheets, the positions and number of thermal expansion layers, and the presence/absence of internal wiring or elements arranged inside the laminate.

[Structure of multi-layer ceramic substrate]

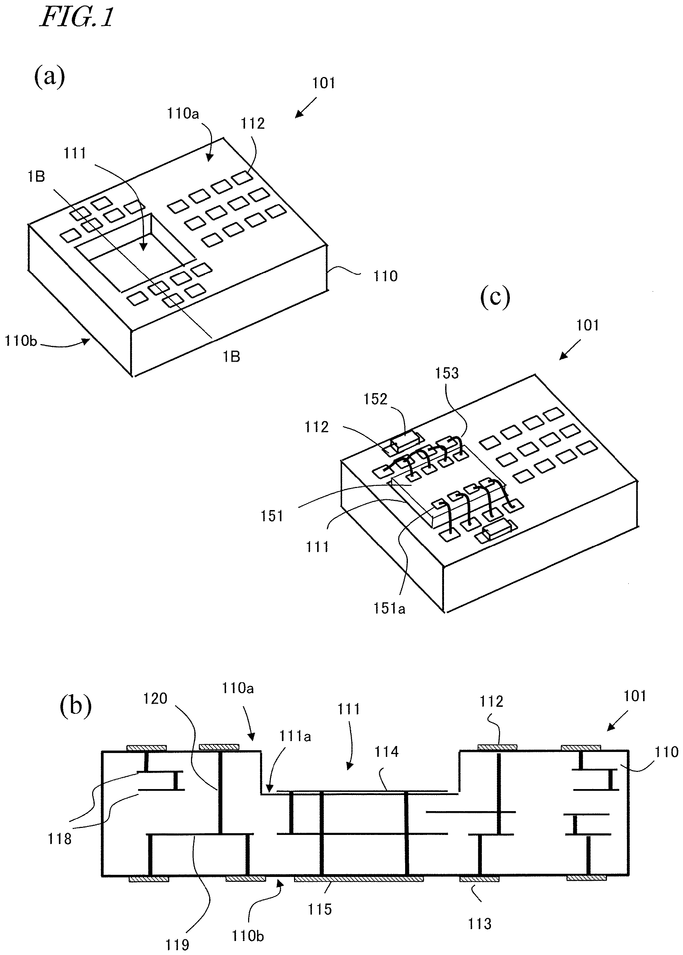

FIG. **1(a)** is a perspective view showing an example of a multi-layer ceramic substrate of the present embodiment, and FIG. **1(b)** shows a cross section taken along line 1B-1B of FIG. **1(a)**.

A multi-layer ceramic substrate **101** includes a ceramic sinter **110** having an upper surface **110a** and a lower surface **110b**. The upper surface **110a** is provided with a cavity **111** for accommodating an electronic component such as a semiconductor IC chip. The cavity **111** has a recessed shape having an opening on the upper surface **110a**. One electrode **112** or a plurality of electrodes **112** may be provided on the upper surface **110a**. One electrode **113** or a plurality of electrodes **113** may be provided on the lower surface **110b**. A heat-radiating electrode **114** is provided on a bottom portion **111a** of the cavity **111** in order to radiate heat from the semiconductor IC accommodated in the cavity **111**. While the multi-layer ceramic substrate **101** shown in FIG. **1** includes one cavity **111**, the multi-layer ceramic substrate may include two or more cavities. In this case, bottom portions **111a** may be at the same level or at different levels in two or more cavities **111**, as will be described below.

A passive element pattern **118** and a conductive via **120** and a wiring pattern **119** may be provided inside the ceramic sinter **110**. The passive element pattern **118** may have a conductivity or a predetermined resistance value, for example, and may form internal wiring, an inductor, a condenser, a stripline, an internal resistor, or the like.

The wiring pattern **119** is made of a conductive thin-layer pattern that is generally parallel to the upper surface **110a** and the lower surface **110b**. The conductive via **120** is made of a via hole extending in a direction connecting between the upper surface **110a** and the lower surface **110b**, and a columnar-shaped conductor filling the via hole. The wiring pattern **119** and the conductive via **120** are connected to the passive element pattern **118**, the wiring pattern **119**, the electrode **112**, the electrode **113**, the electrode **114**, etc., thereby forming a predetermined circuit.

As shown in FIG. **1(b)**, the conductive via **120** connected to the heat-radiating electrode **114** may reach the lower surface **110b** as a radiator. A heat-radiating electrode **115** that is connected to the conductive via **120** connected to the heat-radiating electrode **114** may be further provided on the lower surface **110b.**

The multi-layer ceramic substrate **101** may be a low temperature co-fired ceramic (LTCC) substrate or a high temperature co-fired ceramic (HTCC) substrate. A ceramic material and a conductive material suitable for the sintering temperature, the application, etc., are used for the ceramic sinter **110,** the passive element pattern **118,** the wiring pattern **119,** the electrode **112,** the electrode **113** and the electrode **114.** When the multi-layer ceramic substrate **101** is a low temperature co-fired multi-layer ceramic substrate, a ceramic material and a conductive material that can be sintered in a temperature range of about 800°C to about 1000°C are used. For example, the ceramic material used may be a ceramic material including Al, Si and Sr as its main components and Ti, Bi, Cu, Mn, Na and K as its sub-components, a ceramic material including Al, Si and Sr as its main components and Ca, Pb, Na and K as its sub-components, a ceramic material including Al, Mg, Si and Gd, and a ceramic material including Al, Si, Zr and Mg. The conductive material used may be a conductive material including Ag or Cu. The dielectric constant of the ceramic material is about 3 to about 15. When the multi-layer ceramic substrate **101** is a high temperature co-fired multi-layer ceramic substrate, a ceramic material including Al as its main components, and a conductive material including W (tungsten) or Mo (molybdenum) may be used.

There is no particular limitation on the size of the multi-layer ceramic substrate **101.** The multi-layer ceramic substrate **101** may be produced in a size that is suitable for the application, the number of passive elements included therein, the circuit scale, the size and number of cavities **111,** etc.

FIG. **1(c)** shows a state where a semiconductor IC chip and a capacitor are mounted on the multi-layer ceramic substrate **101.** As shown in FIG. **1(c),** a semiconductor IC chip **151** is arranged in the cavity **111.** For example, the semiconductor IC chip **151** is secured, facing up, by a solder, a heat-conductive adhesive, etc. Electrodes **151a** of the semiconductor IC chip **151** and the electrodes **112** of the multi-layer ceramic substrate **101** are connected together by bonding wires **153.** A passive element or an active element that can be surface-mounted, such as a capacitor **152,** for example, may be connected to the electrode **112** by a solder. Although not shown in the figures, the semiconductor IC chip **151** may be mounted, facing down, in the cavity **111.** In such a case, electrodes corresponding to the electrodes of the semiconductor IC chip **151** are provided on the bottom surface of the cavity **111,** and the electrodes on the bottom surface of the cavity **111** are connected to the electrodes of the semiconductor IC chip **151** by reflow soldering, or the like.

[Method for manufacturing multi-layer ceramic substrate]

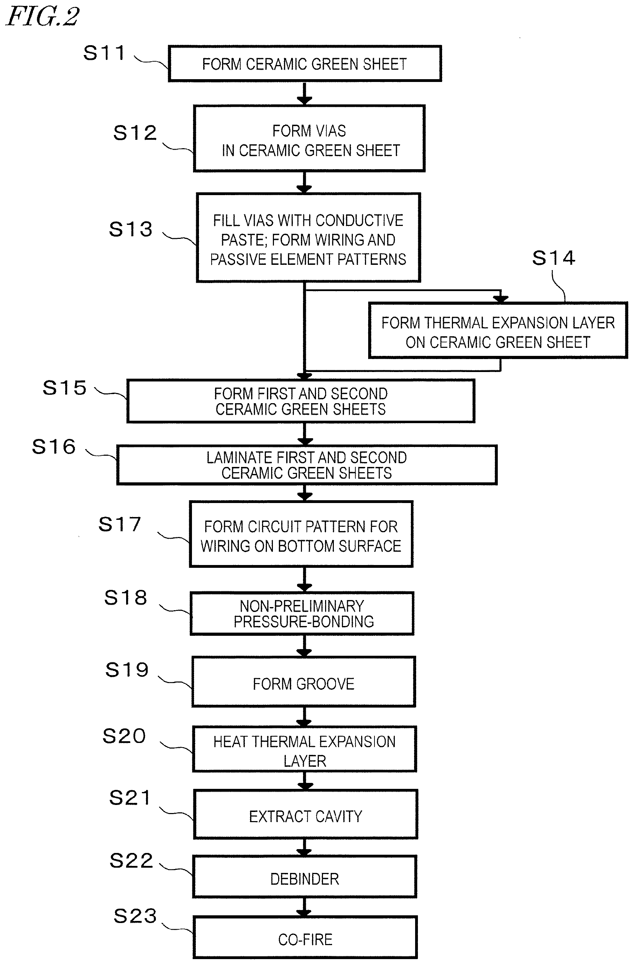

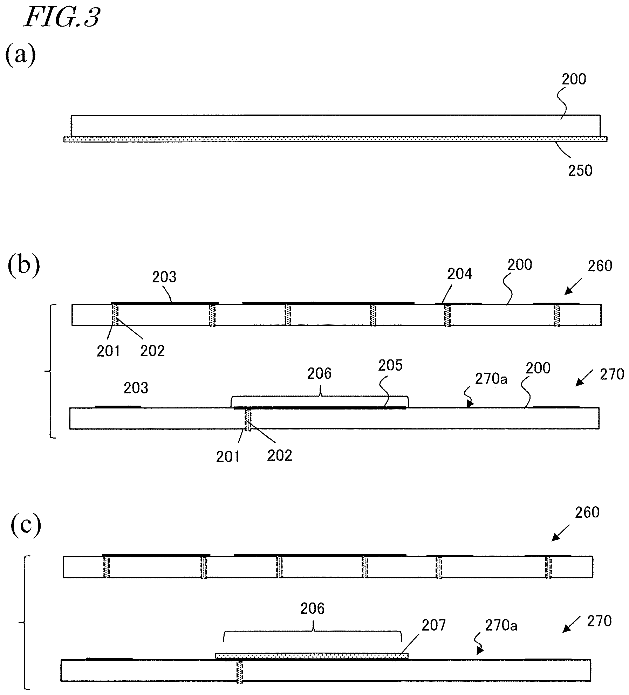

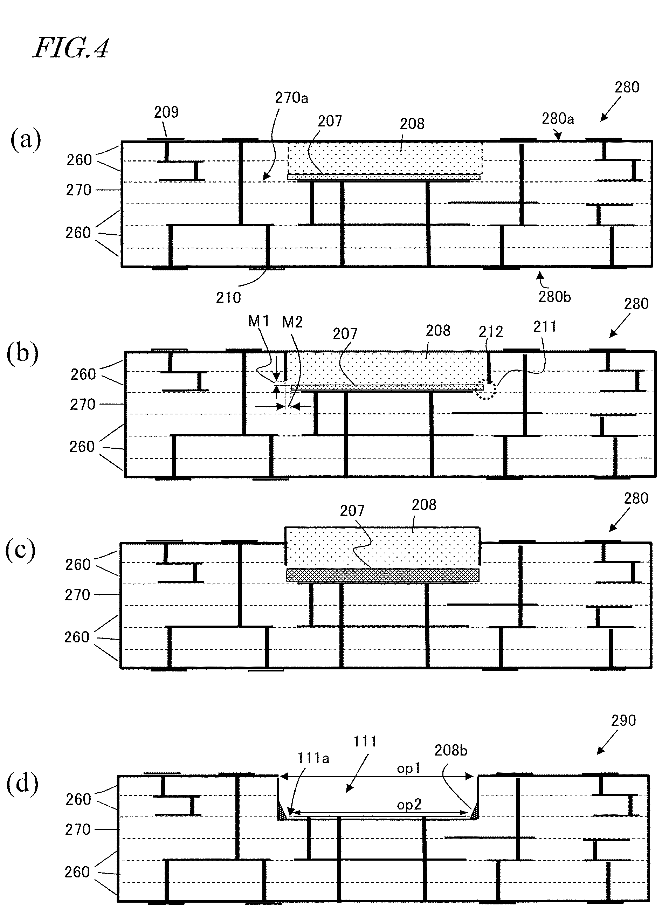

A method of producing a multi-layer ceramic substrate will be described. FIG. **2** is a flow chart showing a method of prducing a multi-layer ceramic substrate. FIG. **3** and FIG. **4** are process step cross-sectional views showing a method of producing a multi-layer ceramic substrate. Referring to FIG. **2,** FIG. **3** and FIG. **4,** a method of producing a multi-layer ceramic substrate of the present embodiment will be described. The following description is directed to an example where ceramic green sheets are laminated together to form one multi-layer ceramic substrate, but two or more multi-layer ceramic substrates may be formed.

1. Step of preparing first and second ceramic green sheets

(1) Preparation of ceramic green sheets

First, a ceramic material is prepared. A ceramic material including elements as described above is prepared and subjected to preliminary sintering at 700°C to 850°C, for example, as necessary, and pulverized into grains. A glass component powder, an organic binder, a plasticizer and a solvent are added to the ceramic material, thereby obtaining a slurry of the mixture. A powder of the conductive material described above is mixed with an organic binder and a solvent, etc., thereby obtaining a conductive paste.

A layer of the slurry having a predetermined thickness is formed on a carrier film **250** by using a doctor blade method, a rolling (extrusion) method, a printing method, an inkjet application method, a transfer method, or the like, and the layer is dried. The dried slurry layer has a thickness of 20 $\mu$m to 200 $\mu$m, for example. The slurry layer is severed to obtain a plurality of ceramic green sheets **200** as shown in FIG. **3(a)** (S11).

(2) Formation of via pattern, wiring pattern, passive element pattern

As shown in FIG. **3(b),** in accordance with a circuit to be formed in the multi-layer ceramic substrate, via holes **201** are formed in the plurality of ceramic green sheets **200** by using a laser, a mechanical puncher, or the like, (S12), and the via holes **201** are filled with a conductive paste **202** by using a screen printing method (S13). A conductive paste is printed on the ceramic green sheets by using a screen printing, or the like, to form a wiring pattern 203 and a passive element pattern **204** on the ceramic green sheet **200** (S13). The diameter of the via holes **201** is 60 $\mu$m to 100 $\mu$m, for example, and the thickness of the wiring pattern **203** and the passive element pattern **204** is 5 $\mu$m to 35 $\mu$m, for example.

The via pattern, the wiring pattern and the passive element pattern to be formed may vary for each green sheet depending on the position (level) of the ceramic green sheet **200**. The plurality of ceramic green sheets **200** are classified into first ceramic green sheets **270** and second ceramic green sheets **260**. The first ceramic green sheet **270** has a primary surface **270a** to be the bottom surface of the cavity, and a region **206** to be the bottom surface of the cavity is located on the primary surface **270a**. An electrode pattern **205** of a heat-radiating electrode may be formed in the region **206**. No thermal expansion layer is formed on the second ceramic green sheet **260**.

(3) Preparation of thermal expansion layer

A thermal expansion layer whose thickness increases when heated is prepared. A thermal expansion layer paste is prepared and the thermal expansion layer is formed by printing using screen printing, or the like. When screen printing is used, patterns to be formed can easily be aligned with each other. In such a case, there are advantages such as being able to freely and easily determine the shape of the thermal expansion layer, being able to easily adjust the thickness thereof, etc.

The thermal expansion layer includes a thermal expansion material that expands when heated. The expansion of the thermal expansion material increases the thickness of the thermal expansion layer, thereby displacing a portion of the ceramic green sheet that is located over the thermal expansion layer. It is preferred that the thickness of the thermal expansion layer increases when heated, and it is preferred that the thickness increases by a factor of 2 or more. That is, it is preferred that the expansion factor is 2 or more. It is more preferred that the thickness of the thermal expansion layer increases when heated by a factor of 2 or more and 12 or less, for example.

For example, the thermal expansion layer paste includes thermally-expansive microcapsules made of a thermoplastic resin that encapsulate a hydrocarbon that is in liquid form at normal temperature as the thermal expansion material, and includes organic materials such as a resin and a solvent. The thermally-expansive microcapsules have an average particle size of 5 $\mu$m to 50 $\mu$m, for example, and each include an outer shell made of a thermoplastic resin and a low boiling hydrocarbon filling the inside of the outer shell that is in liquid form at normal temperature. When heated at a temperature in the range of about 70°C to about 260°C, for example, the low boiling hydrocarbon evaporates and the outer shells soften at the same time, thereby forming independent hollow bubbles. That is, the microcapsules expand. For example, expansive microcapsules of various average particle sizes, thermal expansion start temperatures and maximum expansion temperatures are commercially available, and they can be used. Preferably, the thermally-expansive microcapsule is selected so that the thickness of the thermal expansion layer reaches its maximum at a temperature that is higher than the heating temperature for final pressure-bonding to be described below and lower than the heating temperature for debindering. For example, when 80°C is selected as the heating temperature for final pressure-bonding and 350°C as the heating temperature for debindering, the thermal decomposition of the binder, and the like, starts when the temperature increases past about 200°C. Therefore, the thermally-expansive microcapsule to be selected for use in the thermal expansion layer is designed so that the thermal expansion layer expands at a temperature of 80°C or more and 200°C or less and reaches its maximum volume preferably at about 100°C to about 150°C. Then, it is possible to expand the thermal expansion layer without inhibiting the pressure-bonding of the ceramic green sheets during the final pressure-bonding process and while the binder is included in the green sheet laminate. Thus, it is possible to avoid the problem that the green sheet laminate becomes brittle because the binder is removed when forming the cavity, making it difficult to handle the green sheet laminate.

The average particle size of the thermally-expansive microcapsules may influence the flatness of the bottom portion **111a** of the cavity **111**. When there is a need for a smoother bottom portion **111a**, it is preferred to use thermally-expansive microcapsules having an average particle size that is as small as possible within the range described above, e.g., 10 $\mu$m, so that the unevenness of the bottom portion of the cavity **111** is reduced and the bottom portion becomes smooth. Moreover, in order to reduce the unevenness of the bottom surface of the cavity formed, an unevenness improving material having a size smaller than the thermal expansion material so as to fill the gaps may be added to the thermal expansion layer paste. For example, acrylic beads, or the like, may be used as the unevenness improving material.

(4) Formation of thermal expansion layer

The thermal expansion layer is arranged on the first ceramic green sheet **270**. As shown in FIG. **3(c),** a thermal expansion layer **207** is formed in the region **206** to be the bottom surface of the cavity on the primary surface **270a** of the first ceramic green sheet **270** (S14). As described above, a sheet-shaped thermal expansion layer **207** may be arranged, or the thermal expansion layer **207** may be formed by, for example, screen printing a paste. No thermal expansion layer is arranged on the second ceramic green sheet **260**. Thus, a first ceramic green sheet **270** with a thermal expansion layer arranged thereon and at least one second ceramic green sheet **260** with no thermal expansion layer arranged thereon are prepared (S15). The thickness of the thermal expansion layer **207** is preferably 10 $\mu$m or more and 50 $\mu$m or less. If the thermal expansion layer is thinner than the thermally-expansive microcapsules, the thermally-expansive microcapsules sink into the ceramic green sheets, thereby deforming the ceramic green sheets. If the thermal expansion layer is too thick, it will inhibit the pressure-bonding between the ceramic green sheets. The thickness of the thermal expansion layer **207** is preferably greater than or equal to the average particle size of the thermally-expansive microcapsules.

In the present embodiment, since the multi-layer ceramic substrate **101** includes one cavity **111,** one thermal expansion layer **207** is arranged on the first ceramic green sheet **270** in FIG. **3(c)**. When the multi-layer ceramic substrate **101** includes two or more independent cavities **111** having their bottom surfaces at the same level, the thermal expansion layer **207** is provided in each of the regions to be the bottom surfaces of the two or more independent cavities **111.**

2. Step of obtaining green sheet laminate

The first and second ceramic green sheets **270** and **260** are sequentially laminated together with preliminary pressure-bonding therebetween, thereby forming a green sheet laminate (S16). The second ceramic green sheets **260** and the first ceramic green sheet **270** described above are sequentially laminated together with preliminary pressure-bonding therebetween so as to form a circuit as designed. The total number of layers of the first and second ceramic green sheets **270** and **260** in a green sheet laminate **280** is 4 to 20, for example. The procedure of preliminary pressure-bonding and lamination is in accordance with an ordinary method of producing a multi-layer ceramic substrate. The lamination of the first and second ceramic green sheets **270** and **260** may be performed under a reduced pressure to make it easier to remove bubbles between sheets.

In order to form the space of the cavity **111,** one or more second ceramic green sheet **260** is laminated on the first ceramic green sheet **270** with the thermal expansion layer sandwiched therebetween. The second ceramic green sheet **260** may be arranged also under the first ceramic green sheet **270** to ensure the strength of the bottom of the cavity **111** to arrange the above-described circuit thereon.

Thus, the green sheet laminate **280** is obtained as shown in FIG. **4(a).** In this process, the first ceramic green sheet **270** is arranged so that the primary surface **270a** of the first ceramic green sheet **270** is located at a level (i.e., a height position in the lamination direction of the green sheet laminate) that is to be the bottom portion of the cavity.

While the multi-layer ceramic substrate **101** includes one cavity **111** in the present embodiment, it may include two or more cavities. When the multi-layer ceramic substrate includes two or more cavities **111** having different bottom surface levels, two or more first ceramic green sheets **270** are arranged so that the primary surface **270a** of each of the two or more first ceramic green sheets **270** is located at a level (i.e., a height position in the lamination direction of the green sheet laminate) that is to be the bottom portion of the corresponding cavity.

The thermal expansion layer **207** is located in a region to be the bottom portion of a portion **208** to be the cavity. The portion **208** to be the cavity is a part of the second and/or first ceramic green sheet until it is separated by a groove **212** or the thermal expansion layer **207.**

As necessary, an electrode pattern **209** and an electrode pattern **210** are formed on an upper surface **280a** and a lower surface **280b,** respectively, of the green sheet laminate **280** (S17). An overcoat material may be further arranged around the electrode pattern **209** and the electrode pattern **210.**

3. Final pressure-bonding step

Next, the first and second ceramic green sheets **270** and **260** of the green sheet laminate **280** are pressure-bonded together (S18). For example, the green sheet laminate **280** is set in a frame, and the final pressure-bonding is performed by using a cold isostatic pressing (CIP) device, or the like. The entire green sheet laminate **280** may be heated during the final pressure-bonding so that the resin in the first and second ceramic green sheets **270** and **260** and the gluing agent in the conductive paste are softened to adhere with each other. For the heating, it is preferred to use a temperature such that the thermal expansion layer **207** does not expand. The temperature at which the thermal expansion layer **207** starts expanding is dictated primarily by the characteristics of the thermally-expansive microcapsules included in the thermal expansion layer **207.** For example, the entire green sheet laminate **280** is heated in a temperature range of 60°C to 90°C.

4. Groove forming step

The groove **212** is formed on the green sheet laminate **280** for extracting the portion **208** to be the cavity (S19). Specifically, the groove **212** having a depth from the upper surface **280a** along the lamination direction of the green sheet laminate **280** is formed so as to extend along the outline of the portion **208** to be the cavity as shown in FIG. **4(b).** The groove **212** may be formed by laser machining using YAG, or the like, or by punching using a blade shape of a knife cutter, or the like. The width of the groove **212** is preferably 10 μm to 200 μm, for example. When the width of the groove **212** is less than 10 μm, the two opposing side surfaces that define the groove **212** may deform and come into contact with each other due to some external force after the formation of the groove **212.** When the side surfaces come into contact with each other, it may become difficult to extract the portion **208** to be the cavity.

The groove **212** may not reach the thermal expansion layer **207** but may have a depth with a margin **M1** in the lamination direction of the green sheet laminate **280.** That is, the bottom portion of the groove **212** and the thermal expansion layer **207** may be separated from each other by the margin **M1** in the lamination direction. When the groove **212** runs through the thermal expansion layer **207** and reaches a ceramic green sheet that is located below the thermal expansion layer **207,** the groove **212** located below the thermal expansion layer **207** remains after sintering the green sheet laminate **280,** even after the extraction of the portion **208** to be the cavity and the removal of the thermal expansion layer **207.** Such a groove will lower the strength of the multi-layer ceramic substrate obtained by sintering. With the provision of the margin **M1,** it is possible to prevent the groove **212** from running through the thermal expansion layer **207** because of the precision of the device for forming the groove **212** being insufficient, variations in the formation of the groove **212,** etc. Similarly, the groove **212** may have a margin **M2** from the end portion of the thermal expansion layer **207** in the horizontal direction (the direction perpendicular to the lamination direction of the green sheet laminate **280**).

Note that although the groove **212** for extracting the portion **208** to be the cavity is provided in the green sheet laminate **280** in the present embodiment, the groove **212** may be absent when the depth of the cavity to be formed is as small as 50 $\mu$m or less.

As described above, when the green sheet laminate forms a large substrate that is a collection of multi-layer ceramic substrates **101,** separation grooves for separating into individual substrates after sintering may be similarly formed at this point by using a knife cutter, or the like.

5. Step of expanding thermal expansion layer

The thermal expansion layer **207** is expanded by heat (S20). Specifically, the green sheet laminate **280** is held at a temperature such that the thickness of the thermal expansion layer **207** increases. This temperature is higher than the heating temperature for final pressure-bonding and lower than the heating temperature for debindering. For example, the green sheet laminate **280** is held at a temperature in the range of 110°C or more and less than 200°C for 1 min or more and 30 min or less. Preferably, the holding temperature is 150°C or less. Herein, in order to remove the binder after the expansion of the thermal expansion layer, the upper limit of the temperature for expanding the thermal expansion layer **207** is set to a temperature that is lower than the temperature at which the binder starts to be removed. However, the thermal expansion layer may be expanded after the debindering step or during the debindering step. In such a case, the thermal expansion layer may be expanded at a higher temperature.

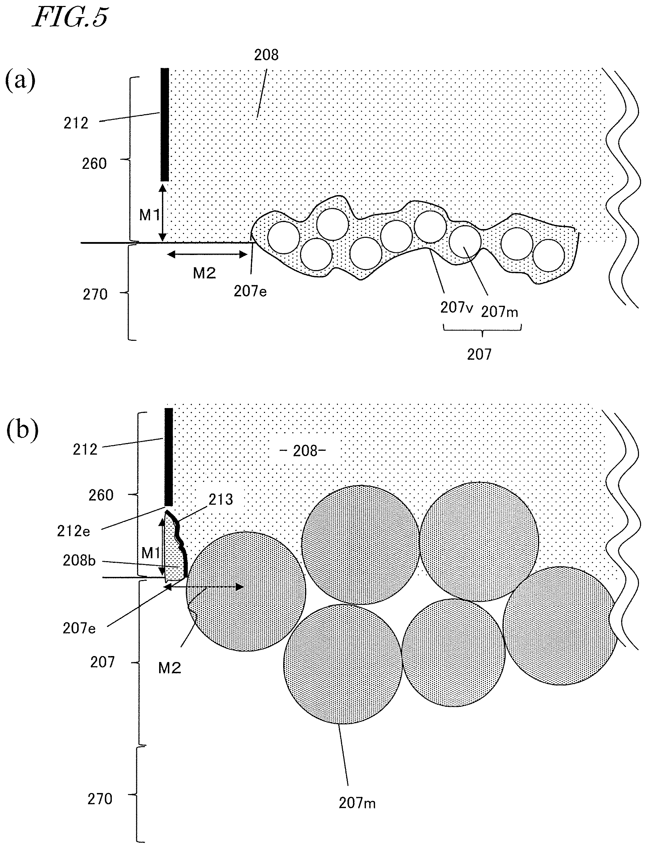

FIGS. **5(a)** and **5(b)** are schematic diagrams showing, on an enlarged scale, the vicinity of the end portion of the thermal expansion layer **207** for illustrating the expansion of the thermal expansion layer **207** and the separation of the portion **208** to be the cavity. In FIG. **5,** different elements are scaled differently for the sake of illustration, and the figure does not represent the actual scale. The thermal expansion layer **207** is present in a state where thermal expansion layer microcapsules **207m** and an organic material **207v** are mixed together until the expansion of the thermal expansion layer **207** after the final pressure-bonding step. As described above, there may be the margin **M2** in the horizontal direction so that an end portion **207e** of the thermal expansion layer **207** is located on the inner side of the opposite ends of the portion **208** to be the cavity in order to avoid a crack extending continuous from the bottom portion of the cavity. In the lamination direction of the green sheet laminate **280,** there may be the margin **M1** provided between the groove **212** and the thermal expansion layer **207.** The thermal expansion layer microcapsules **207m** are bonded to the portion **208** to be the cavity and the first ceramic green sheet **270** by means of the organic material **207v.**

In the process of increasing the temperature from this bonded state, the organic material **207v,** the binder of the ceramic green sheets, etc., become soft, while the thermal expansion layer microcapsules **207m** expand, thereby losing the adhesion. Therefore, peeling occurs between the thermal expansion layer microcapsules **207m** and the portion **208** to be the cavity and between the thermal expansion layer microcapsules **207m** and the first ceramic green sheet **270.** Moreover, as the thermal expansion layer microcapsules **207m** expand, the surrounding first and second ceramic green sheets are pushed apart from each other. As a result, the portion **208** to be the cavity and the first ceramic green sheet **270,** which have been bonded together with the thermal expansion layer **207** interposed therebetween, peel off and come off the thermal expansion layer **207.**

Thus, the thickness of the thermal expansion layer **207** increases as shown in FIG. **4(c).** In this process, as shown in FIG. **5(b),** when at least one of the margin **M1** and the margin **M2** is provided between the end portion **207e** of the thermal expansion layer **207** and a bottom portion **212e** of the groove **212,** the portion **208** of the ceramic green sheet to be the cavity remains connected to the rest in a portion **211** where the margin **M1** and the margin **M2** are provided. However, as the thermal expansion layer microcapsules **207m** expand, a shear stress acts on the portion **211** due to the displacement of the portion **208** to be the cavity and the stress from the expansion of the thermal expansion layer microcapsules **207m.**

As a result, in the portion **211** where the margin **M1** and the margin **M2** are provided, there occurs a crack **213** starting from the bottom portion **212e** of the groove **212** and reaching the interface between the first ceramic green sheet **270** and the second ceramic green sheet **260** or the thermal expansion layer **207** (the thermal expansion layer microcapsules **207m**). Thus, the entire outline of the portion **208** to be the cavity is separated from the green sheet laminate **280.** As a result, a gap is formed between the two ceramic green sheets that sandwich the thermal expansion layer **207** therebetween, and the portion **208** to be the cavity is lifted and displaced by the thermal expansion layer **207.** In this process, as shown in FIG. **5(b),** if the direction in which the crack **213** extends is not perpendicular to the laminating surface of the green sheet, a part of the portion **208** to be the cavity remains as burrs **208b.**

6. Cavity forming step

As shown in FIG. **4(c),** by extracting the portion **208** to be the cavity displaced by the expansion of the thermal expansion layer **207,** the cavity **111** is formed in the green sheet laminate **280** (S21). The side surface of the portion **208** to be the cavity is completely separated from the green sheet laminate **280.** Moreover, as the thermal expansion layer **207** expands and the adhesive strength lowers, there occurs a gap also between the thermal expansion layer **207** and the portion **208** to be the cavity and between the thermal expansion layer **207** and the green sheet laminate **280.** Therefore, by holding the green sheet laminate **280** with the upper surface **280a** facing down, the portion **208** to be the cavity drops off the green sheet laminate **280** by virtue of its own weight, thus obtaining a green sheet laminate **290** provided with the cavity **111** having an opening on the upper surface **280a.** If the portion **208** to be the cavity does not easily drop by virtue of its own weight because of the groove width being small, the portion **208** to be the cavity may be removed by using a tape, a suction head, or the like.

In this process, a part or whole of the thermal expansion layer **207** may come off together with the portion **208** to be the cavity, or the entire thermal expansion layer **207** may remain stuck on the bottom of the cavity **111.** That is, a part or whole of the thermal expansion layer **207** may be removed together with the portion **208** to be the cavity. If a part or whole of the thermal expansion layer **207** remains in the green sheet laminate **280,** most of it disappears in the debindering step to be described below. The thermal expansion layer **207** that does not disappear in the debindering step can be made to disappear in the sintering step. If there is a portion that remains after the sintering step, it may be immersed in an acid, an alkali or a fluoride after the sintering step, and it may be further cleaned by using ultrasonic waves, etc., as necessary. When the thermal expansion layer includes a portion that remains after the sintering step as described above, a pretreatment of cleaning a thermal expansion material, etc., may be performed before forming the thermal expansion layer by using a thermal expansion layer paste including the thermal expansion material.

As described above, depending on the lengths of the margin **M1** and the margin **M2,** the crack **213** occurs in a slant direction with respect to the lamination direction of the ceramic green sheets, and the burrs **208b** occur on the bottom portion **111a** of the cavity **111.** When the burrs **208b** occur, the length **op2** of a flat bottom portion **111b** is shorter than the length of the opening **op1** of the cavity **111,** as shown in FIG. **4(d).**

7. Debindering step

The binder is removed from the green sheet laminate **290** having the cavity **111** (S22). Specifically, organic components such as a resin and a solvent included in the green sheet laminate **290** are heated and removed. For example, it is held at a temperature in the range of 200°C or more and 600°C or less for 120 min or more and 600 min or less. The holding temperature may be constant or may be varied. For example, the green sheet laminate **290** may be heated up to 500°C, and then it may be cooled gradually or the holding temperature may be lowered gradually. Through this step, the resin, the solvent and the thermal expansion layer **207** included in the green sheet laminate **290** disappear (evaporate). For example, the thermal expansion layer **207** disappears at a temperature in the range of about 350°C to 600°C. It was found that if the temperature range is the same as the debindering temperature range, it is possible to expand the thermal expansion layer during the debindering step, as described above, and to cause most of the remaining thermal expansion layer to disappear during the debindering after the cavity is formed. Moreover, if there remain traces of the thermal expansion material on the bottom surface of the cavity formed, a material that disappears in this temperature range can be used, as an unevenness improving material, to fill the gaps in the thermal expansion material. The unevenness improving material may be acrylic beads, or the like.

This debindering step may be performed successively after the step of expanding the thermal expansion layer, and the cavity may be formed after the debindering step. By successively performing the two steps, it is possible to shorten the manufacturing process.

In the debindering step, since the binder is removed and the green sheet laminate becomes brittle, the thermal expansion layer may be expanded after the debindering step to remove the portion to be the cavity, thereby forming the cavity. In such a case, it is preferred that the green sheet laminate is held at a temperature such that the thermal expansion layer does not expand in the debindering step.

8. Sintering step

The debindered green sheet laminate **290** is sintered (S23). Specifically, the green sheet laminate **290** is held at a sintering temperature for the ceramic included in the ceramic green sheet, thereby sintering the ceramic. For example, it is held at a temperature in the range of 850°C or more and 940°C or less for 100 min or more and 180 min or less. Thus, it is possible to obtain a multi-layer ceramic substrate shown in FIG. **1(b).**

This sintering step may be performed successively after the debindering step. For example, using a continuous furnace, the green sheet laminate with a cavity formed therein is held at a temperature in the range of 200°C or more and 600°C or less for 120 min or more and 600 min or less, and then held at a temperature in the range of 850°C or more and 940°C or less for 100 min or more and 180 min or less. Moreover, the holding temperature may be constant or may be varied. For example, the green sheet laminate **290** may be heated up to 200°C and slowly heated up to 600°C, and then it may be heated to a temperature in the range of 850°C or more and 940°C or less. By successively performing the two steps, it is possible to shorten the manufacturing process.

When the green sheet laminate forms a large substrate that is a collection of multi-layer ceramic substrates **101,** it is possible to obtain a plurality of multi-layer ceramic substrates by severing the large substrate, obtained by sintering, along separation grooves.

According to the method of producing a multi-layer ceramic substrate of the present embodiment, the thickness of the thermal expansion layer increases when heated, thereby displacing a portion of the green sheet laminate to be the cavity. The thermal expansion layer is thin before being heated, and it does not inhibit the adhesion between two ceramic green sheets when it is interposed between the ceramic green sheets. Therefore, it is possible to prevent ceramic green sheets from being shifted from each other when laminating the ceramic green sheets together to form a green sheet laminate and when forming a groove along the outline of the cavity. Moreover, it is possible to maintain a high formability of the green sheet laminate, e.g., it is possible to increase the adhesion between ceramic green sheets in the green sheet laminate and to ensure a good flatness of the cavity bottom surface.

The thickness of the thermal expansion layer increases significantly, thereby displacing the portion to be the cavity of the green sheet laminate. Therefore, even if the groove along the outline of the cavity is not completely connected to the thermal expansion layer, the shear stress due to the displacement causes a crack in the ceramic green sheet, thereby separating the portion to be the cavity from the green sheet laminate. The shear stress is unlikely to cause a crack in an unintended portion. Therefore, even with an alignment error taken into account, it is possible to reliably separate the portion to be the cavity from the green sheet laminate with a high yield. Moreover, since it is possible to check whether the cavity has been formed properly before sintering, it is possible to exclude defective prodcuts before sintering. Thus, it is possible to provide a method of producing a multi-layer ceramic substrate with a good mass productivity and with a high yield.

By selecting a material that disappears at a temperature for the debindering step or the sintering step, most of the thermal expansion layer disappears in these steps. Therefore, it is possible to prevent the decrease in the flatness or the cleanliness of the cavity bottom surface due to impurity remaining on the bottom surface of the cavity. Thus, it is possible to obtain clean electrode surfaces and thermal vias. Since the cavity is maintained even in the sintered multi-layer ceramic substrate, it is possible to accommodate a semiconductor device, or the like, without cleaning the residue. With a semiconductor device accommodated in the cavity, it is possible to achieve a high degree of integration and a low profile for multi-layer ceramic substrates.

[Other embodiments]

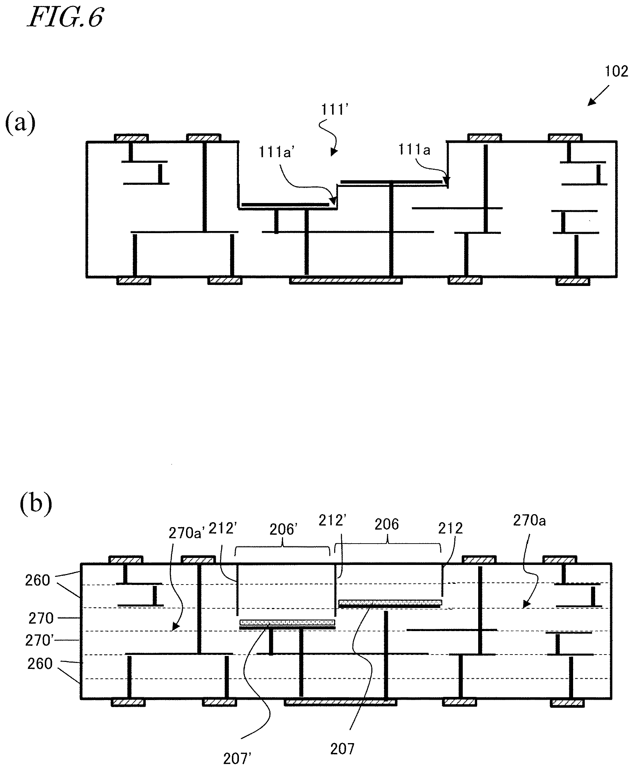

While the embodiment described above is directed to a multi-layer ceramic substrate whose cavity has one flat bottom surface, a multi-layer ceramic substrate may include a plurality of cavities having the same depth, or may include a plurality of cavities having different depths. A multi-layer ceramic substrate may include a cavity having a plurality of bottom surfaces of different heights. For example, as shown in FIG. **6(a),** a multi-layer ceramic substrate **102** may include a cavity **111'** having a first bottom portion **111a** and a second bottom portion **111a'** at different heights. While the second bottom portion **111a'** is located deeper than the first bottom portion **111a** in the cavity **111'** in the present embodiment, the second bottom portion **111a'** may be located shallower than the first bottom portion **111a.**

As shown in FIG. **6(b),** first, there are prepared a first ceramic green sheet **270** with a thermal expansion layer **207** arranged in the region **206** to be the first bottom portion **111a** and a third ceramic green sheet **270'** with a thermal expansion layer **207'** arranged in a region **206'** to be the second bottom portion **111a'**. Then, the first ceramic green sheet **270** and the third ceramic green sheet **270'** are arranged so that the primary surface **270a** of the first ceramic green sheet **270** and a primary surface **270a'** of the third ceramic green sheet **270'** are at the levels of the first bottom portion **111a** and the second bottom portion **111a'** when forming the green sheet laminate. A groove **212'** and the groove **212** are formed at positions to be the side surface of the cavity **111'**. Moreover, it is preferred that the groove **212'** is provided at the boundary between the region **206** and the region **206'** so as to reach the vicinity of the primary surface

270a' of the third ceramic green sheet 270'. The multi-layer ceramic substrate 102 can be manufactured with the other conditions being equal to those of the method described above. In this case, the thickness of the thermal expansion layer 207 as expanded may be different from the thickness of the thermal expansion layer 207' as expanded.

While the cavity 111' has one first bottom portion 111a and one second bottom portion 111a' in FIG. 6, the multi-layer ceramic substrate may include a cavity having three or more bottom portions at different levels. In such a case, three first ceramic green sheets 270 including thermal expansion layers at different positions from each other are prepared, and these three first ceramic green sheets 270 are arranged in the green sheet laminate so as to be at different levels from each other.

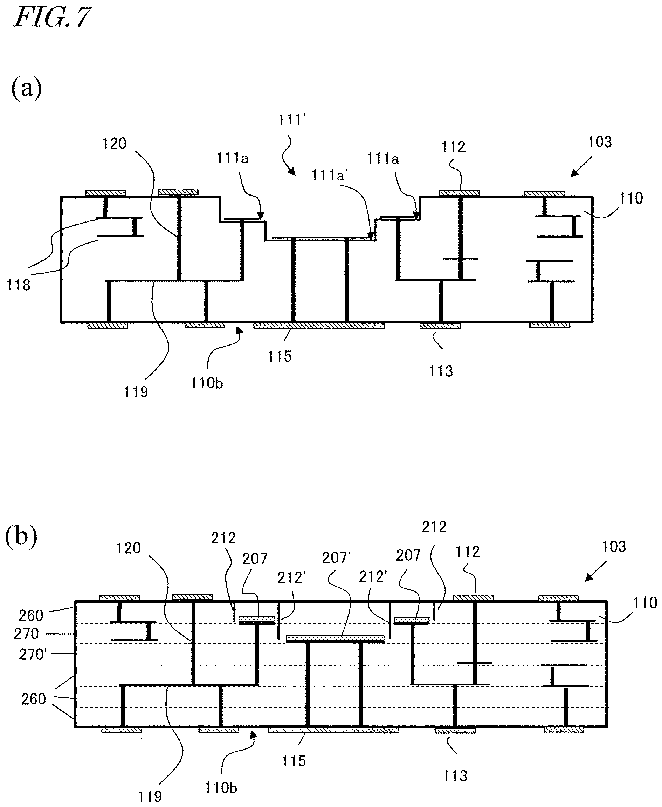

Moreover, as shown in FIG. 7(a), in a multi-layer ceramic substrate 103, the cavity 111' may have one second bottom portion 111a', and two first bottom portions 111a located with the second bottom portion 111a' sandwiched therebetween. In such a case, as shown in FIG. 7(b), there are prepared a first ceramic green sheet 270 including two thermal expansion layers 207 arranged at positions corresponding to the two first bottom portions 111a, and a third ceramic green sheet 270' including a thermal expansion layer 207' arranged at a position corresponding to the second bottom portion 111a'. The first ceramic green sheet 270 and the third ceramic green sheet 270' are laminated together so as to be at different levels from each other.

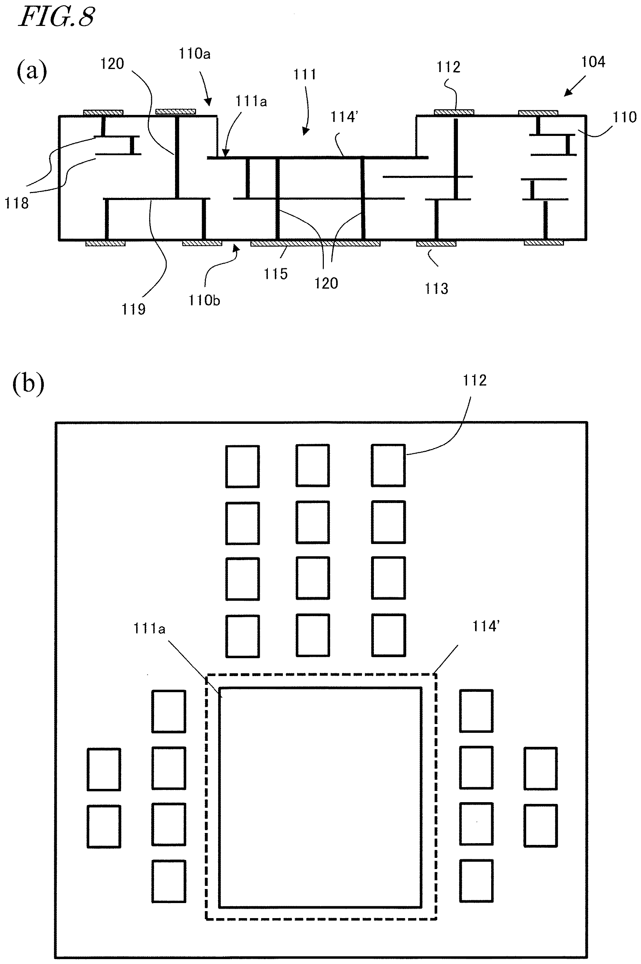

In the embodiment described above, the electrode 114 located on the bottom portion 111a of the cavity 111 is smaller than the bottom portion 111a. However, the electrode 114 may be larger than the bottom portion 111a. FIG. 8(a) and FIG. 8(b) are a cross-sectional view and a plan view, respectively, of a multi-layer ceramic substrate 104. The multi-layer ceramic substrate 104 includes an electrode 114' that is larger than the bottom portion 111a of the cavity 111. Like the embodiment shown in FIG. 1, etc., the conductive via 120 is connected to the electrode 114', and the conductive via 120 is connected to the heat-radiating electrode 115 provided on the lower surface 110b of the ceramic sinter 110, for example. The electrode 114' is used as a heat-radiating electrode or a ground electrode for an electronic component arranged in the cavity 111, for example.

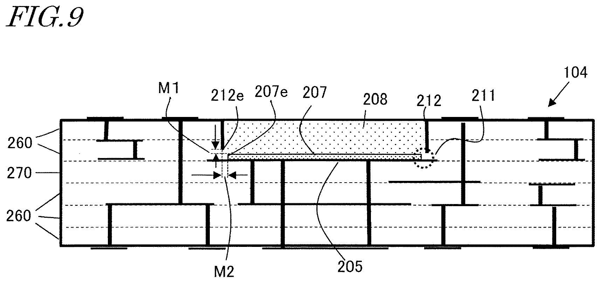

FIG. 8(a) shows the electrode 114' as if a portion thereof that is exposed as the bottom portion 111a of the cavity 111 and a portion thereof that is buried in the ceramic sinter 110 were forming the same plane. However, as shown in FIG. 9, during the manufacturing process of the multi-layer ceramic substrate 104, the thermal expansion layer 207 is arranged only on a portion (to be the cavity 111) of the electrode pattern 205 to be the electrode 114'. Therefore, when forming the green sheet laminate, a portion of the electrode pattern 205 to be the cavity 111 may possibly be depressed by being pressed by the thermal expansion layer 207. In such a case, the electrode 114' of the multi-layer ceramic substrate 104 may include a depressed portion in an area where it is exposed as the bottom portion 111a of the cavity 111.

With the multi-layer ceramic substrate 104, the groove 212 for forming the cavity 111 is located above the electrode pattern 205 during the manufacturing process, as shown in FIG. 9.

Therefore, when at least one of the margin M1 and the margin M2 is provided between the end portion 207e of the thermal expansion layer 207 and the bottom portion 212e of the groove 212, a shear stress acts on the portion 211 due to the expansion of the thermal expansion layer 207, and a crack occurring from the bottom portion 212e of the groove 212 is likely to extend straight. This is because the upper surface of the electrode pattern 205 and the ceramic green sheet, which are made of different materials, are likely to peel off from each other at the boundary therebetween to release the stress. Thus, with the multi-layer ceramic substrate 104, the burrs 208b are unlikely to occur on the bottom portion 111a of the cavity 111, and the burrs 208b, even if produced, will be small.

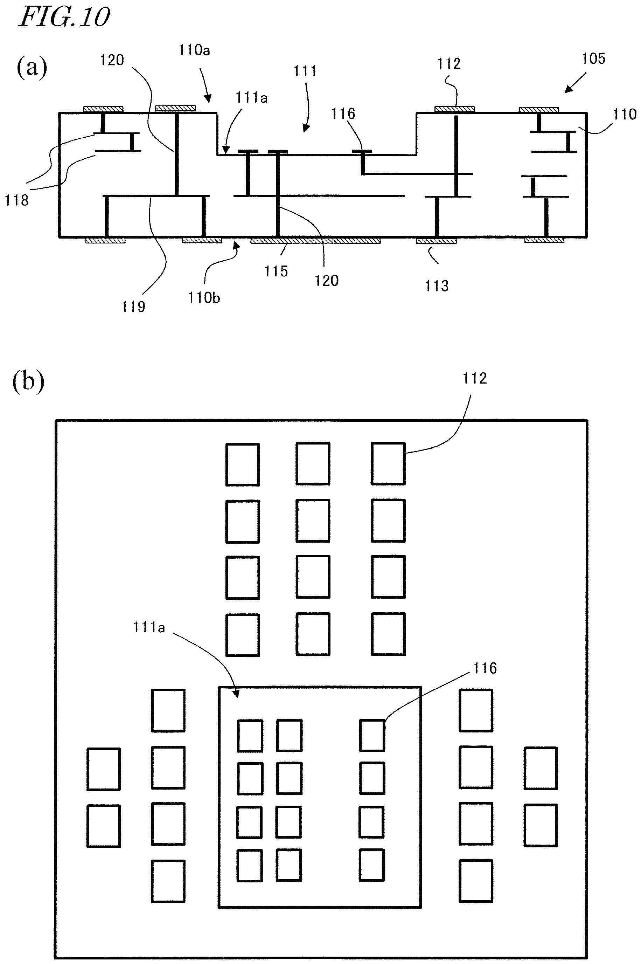

FIG. 10(a) and FIG. 10(b) are a cross-sectional view and a plan view, respectively, of a multi-layer ceramic substrate 105. The multi-layer ceramic substrate 105 includes a plurality of pad electrodes 116 on the bottom portion 111a of the cavity 111. The conductive vias 120 are connected to the pad electrodes 116, and the conductive vias 120 are connected to the wiring pattern 119, the passive element pattern 118, etc.

With the multi-layer ceramic substrate 105, an electronic component such as an integrated circuit can be connected by flip-chip bonding in the cavity 111. Therefore, there is no need to connect bonding wires to an active element accommodated in the cavity 111 as shown in FIG. 1, etc., and it is possible to reduce the height of the multi-layer ceramic substrate 105 with an electronic component mounted thereon. Moreover, another electronic component, another multi-layer ceramic substrate, or the like, can be arranged on the multi-layer ceramic substrate 105.

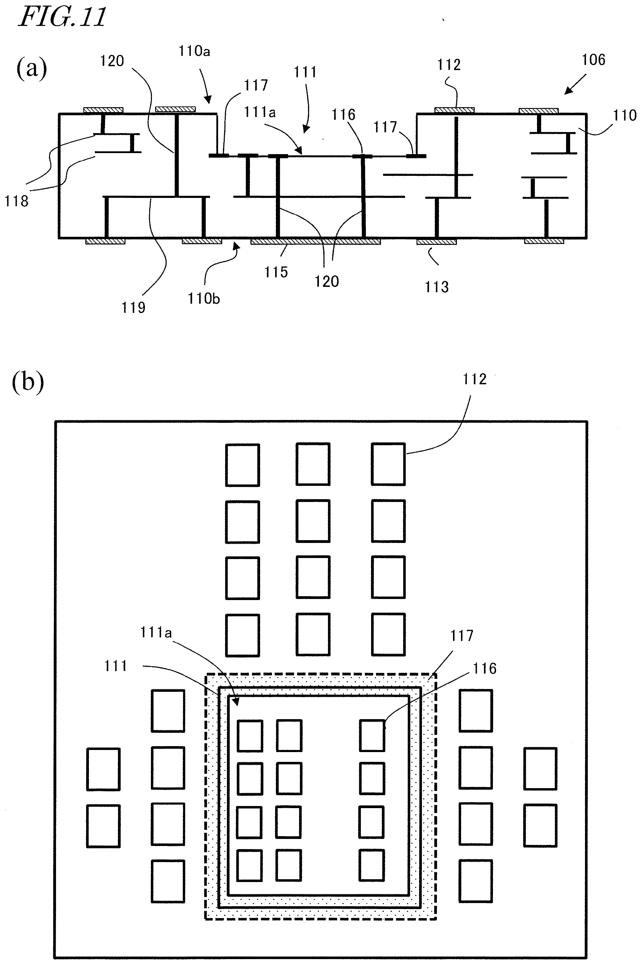

FIG. 11(a) and FIG. 11(b) are a cross-sectional view and a plan view, respectively, of a multi-layer ceramic substrate 106. The multi-layer ceramic substrate 106 is different from the multi-layer ceramic substrate 104 shown in FIG. 10 in that the multi-layer ceramic substrate 106 further includes an electrode 117 that is located below the side surface of the cavity 111, extending along the periphery of the bottom portion 111a. As described above with reference to FIG. 9, when the multi-layer ceramic substrate 106 is manufactured, the groove 212 for forming the cavity 111 is located over the pattern of the electrode 117. Therefore, with the multi-layer ceramic substrate 106, the burrs 208b are unlikely to occur on the bottom portion 111a of the cavity 111, and the burrs 208b, even if produced, will be small.

Note that while the cavity forming step is performed after the step of expanding the thermal expansion layer in the embodiment described above, the cavity forming step may be performed during the step of expanding the thermal expansion layer or during the debindering step. During the expansion step or during the debindering step, as used herein, means that the cavity is formed while the green sheet laminate is held under the condition for the expansion step or the condition for the debindering step.

(Examples)

The results of conducting experiments for the method of producing a multi-layer ceramic substrate of the present embodiment will now be described.

[Example 1]

Characteristics of thermal expansion layer

A thermal expansion layer paste was prepared, and it was confirmed that the thermal expansion layer exhibited a thickness change sufficient for the formation of the cavity at a desired temperature. Ceramic green sheets were produced by forming a ceramic material including Al, Si and Sr as its main components and Ti, Bi, Cu, Mn, Na and K as its sub-components into a sheet shape.
Thermally-expansive microcapsules (F, FN series from Matsumoto Yushi-Seiyaku Co., Ltd.) having average particle sizes and expansion start temperatures shown in Table 1 were prepared as thermal expansion materials. TMC-108 (from Tanaka Kikinzoku Kogyo K.K.) was used as a vehicle, and the thermally-expansive microcapsules and the vehicle were mixed together at a weight ratio of 1:9 to produce a paste. The obtained paste was applied on a PET film so that the thickness as dried is about 0.1 mm and then dried, thereby obtaining samples of thermal expansion layers. A plurality of samples were produced using the thermal expansion materials of Samples 1 to 3. The produced samples were heated at a temperature of 70°C to 130°C, and the change in the thickness of each sample was measured by using a micrometer, and the thickness change of the sample was calculated. Specifically, the thickness change (expansion factor) $\alpha$ with respect to the thickness before being heated was calculated as a numerical value by the following formula, where $t_1$ is the thickness before being heated and $t_2$ is the thickness after being heated.

$$\alpha = t_2 / t_1$$

[Table 1]

| Samples | Particle size ($\mu$m) | Expansion start temperature (°C) |
|---|---|---|
| Sample 1 | 6-10 | 100-110 |
| Sample 2 | 9-15 | 90-100 |
| Sample 3 | 20-30 | 115-125 |

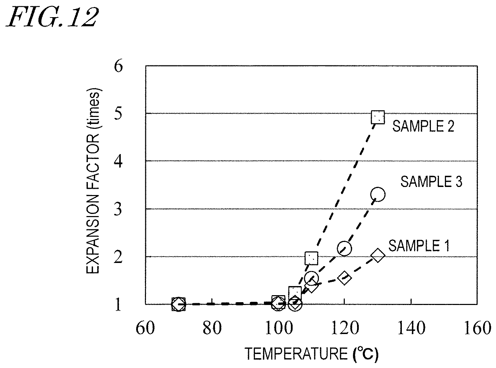

The results are shown in FIG. **12.** The horizontal axis represents the temperature at which heating was done, and the vertical axis represents the thickness change (expansion factor) with respect to the thickness before being heated.
It was found that each sample expands at about 100°C to about 110°C, and the thickness thereof increases by a factor of about 2 to about 5 at 130°C. The temperature range is between the temperature of the final pressure-bonding and the temperature of the debindering in the manufacturing process of the multi-layer ceramic substrate.

[Example 2]

Formation of cavity

The amount of thickness change of the thermal expansion layer that is needed for forming a cavity without forming a groove was examined. Ceramic green sheets having a thickness of 110 $\mu$m were prepared, and six of them were layered together to form a ceramic green sheet laminate. The size of the cavity was 25 mm long, 25 mm wide and 0.1 mm deep. For the thermal expansion layer, the thermal expansion layer paste of Sample 1 described above was applied on a ceramic green sheet by using a screen printing method. The thickness of the thermal expansion layer was 0.01 mm, as measured by observing the cross section of the produced sheet laminate with a microscope. In order to vary the amount of thickness change, the heating temperature when expanding the thermal expansion layer was adjusted in accordance with FIG. **12.** A plurality of samples were produced to evaluate the percentage with which the portion corresponding to the cavity was extracted properly. The results are shown in Table 2. Herein, the percentage of proper extraction refers to the percentage with which the portion corresponding to the cavity was extracted properly because of the thickness change of the thermal expansion layer. That is, for the following results, a study was conducted to determine a predetermined range of the amount of thickness change before and after heating the thermal expansion layer for forming the cavity, without forming, in the green sheet laminate, a groove that has the depth of the cavity and that defines the outline of the cavity.

[Table 2]

| Heating temperature (°C) | Amount of thickness change (expansion factor) (times) | Number of successful extractions | Number of samples tested | Percentage of successful extraction (%) |
|---|---|---|---|---|
| 70 | 1.00 | 0 | 50 | 0 |
| 100 | 1.01 | 0 | 50 | 0 |
| 110 | 1.5 | 0 | 3 | 0 |
| 120 | 2.2 | 1 | 3 | 33.33 |
| 130 | 3.7 | 80 | 80 | 100 |

It can be seen from Table 2 that if the amount of thickness change is about 2.2, it is possible to form the cavity by virtue of the thickness change of the thermal expansion layer with a yield of about 1/3. It can also be seen that if the amount of thickness change is 3.7 times, it is possible to reliably form the cavity. It can be seen from these results that the thickness of the thermal expansion layer preferably increases by a factor of 2 or more and 4 or less by being heated.

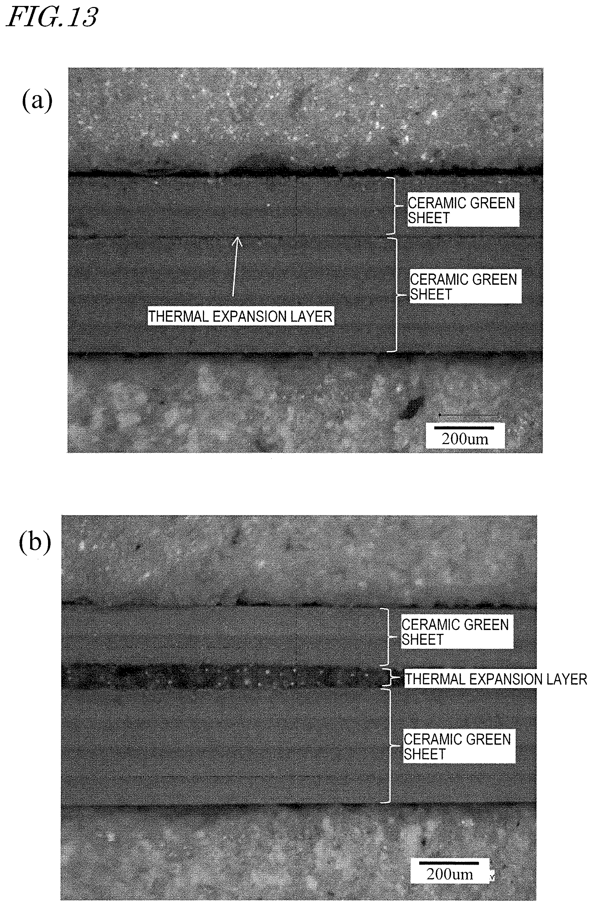

FIGS. **13(a)** and **13(b)** are optical microscopic images before and after the thermal expansion layer is heated, respectively, for a sample that was obtained by laminating and pressure-bonding six layers of ceramic green sheets each having a thickness of 110 $\mu$m, wherein the depth of the cavity was 0.2 mm and the amount of thickness change was 6 times. While it can be seen from FIG. **13(a)** that the thickness of the thermal expansion layer before being heated was about 10 $\mu$m, it can be seen from FIG. **13(b)** that the thickness of the thermal expansion layer after being heated was about 50 $\mu$m.

[Example 3]

Manufacturing multi-layer ceramic substrate

A multi-layer ceramic substrate was manufactured, in which a cavity was formed under the following condition.

First, a ceramic material including Al, Si and Sr as its main components and Ti, Bi, Cu, Mn, Na and K as its sub-components was prepared. A plurality of ceramic green sheets were obtained as described above using the ceramic material prepared.

Next, via holes were formed in the obtained ceramic green sheets by using a laser puncher, and screen printing was used to fill the via holes with a conductive paste and to form wiring patterns. A material including Ag as a conductive material was used as the conductive paste. Moreover, a thermal expansion layer was formed in a region of the first ceramic green sheet to be the bottom surface of the cavity. The thermal expansion layer was formed by a screen printing method using a thermal expansion layer paste so that the thickness as dried would be 10 $\mu$m. In the thermal expansion layer paste, thermally-expansive microcapsules (F, FN series from Matsumoto Yushi Kogyo) were cleaned with ammonium fluoride and used as the thermal expansion material, and acrylic beads (from Sekisui Plastics Co., Ltd.) were added at the same time as the unevenness improving material for the cavity bottom surface.

The obtained first and second ceramic green sheets were successively laminated together by repeating the operation of preliminary pressure-bonding one of the first and second ceramic green sheets and peeling off the carrier film to obtain a green sheet laminate including 4 to 20 layers of ceramic green sheets, specifically, seven layers of ceramic green sheets, each having a thickness of 80 $\mu$m, laminated together. Then, the green sheet laminate was subjected to final pressure-bonding at 17 MPa while being heated to 85°C.

In the green sheet laminate having been subjected to the final pressure-bonding, a groove having a depth of 180 $\mu$m was formed along the outline of the portion to be the cavity by using a chisel blade shape.

Next, the thermal expansion layer of the grooved green sheet laminate was heated to 130°C and held for 15 min. Thus, the thickness of the thermal expansion layer was increased and the portion to be the cavity was displaced.

The displaced portion to be the cavity was easily extracted by a tape, thereby forming the cavity. Then, grooves to be used for separation after sintering were formed.

The green sheet laminate with the cavity formed therein and with separation grooves formed therein was subjected to the debindering step and the sintering step in the range of conditions described above by using a continuous furnace. Thus, a multi-layer ceramic substrate having a cavity was obtained. It was confirmed that although a part of the expanded thermal expansion layer remained on the bottom portion of the cavity when the cavity was formed in the green sheet laminate, most of it had disappeared after the sintering step. Moreover, even traces of thermal expansion layer microcapsules did not remain on the bottom surface of the cavity after sintering. With the multi-layer ceramic substrate obtained through the steps described above, it is possible to form the cavity using substantially the same steps as those of existing multi-layer ceramic substrates, exhibiting a good mass productivity.

[Example 4]

Formation of small cavity

The thickness of the co-fired multi-layer ceramic substrate and the depth of the cavity were varied so as to check whether a small cavity can be produced. Using a production method similar to Example 3, multi-layer ceramic substrates were produced whose thicknesses would be 325 $\mu$m, 650 $\mu$m and 1300 $\mu$m, after being fired. The size of the cavity was 1.3 mm $\times$ 1.3 mm, 2.3 mm $\times$ 2.3 mm. Whether the cavity can be formed was checked while setting the depth of the cavity to 100 $\mu$m, 150 $\mu$m, 200 $\mu$m, 250 $\mu$m and 300 $\mu$m. The results are shown in Table 3.

[Table 3]

| | Substrate Thickness ($\mu$m) | 325 | | 650 | | 1300 | |
|---|---|---|---|---|---|---|---|
| | cavity size (mm) | 1.3×1.3 | 2.3×2.3 | 1.3×1.3 | 2.3×2.3 | 1.3×1.3 | 2.3×2.3 |
| Cavity depth ($\mu$m) | 100 | ○ | ○ | ○ | ○ | ○ | ○ |
| | 150 | ○ | ○ | ○ | ○ | ○ | ○ |
| | 200 | × | × | Δ | ○ | Δ | ○ |
| | 250 | × | × | Δ | ○ | Δ | ○ |
| | 300 | | | Δ | ○ | Δ | ○ |

In Table 3, "○" indicates that a cavity having a desirable shape was formed. "Δ" indicates that the extraction of the cavity was not easy, and the shape of the cavity formed did not have a sufficiently good finish. "×" indicates that a crack occurred on the bottom portion of the cavity.

It was found from the results shown in Table 3 that even small cavities whose planar shapes are 1.3 mm × 1.3 mm and 2.3 mm × 2.3 mm could be formed. It was also found that it was possible to form a cavity without causing a crack on the bottom portion if the depth of the cavity was 1/2 or less of the thickness of the multi-layer ceramic substrate.

[Example 5]

Determination of margin and size of burr

As shown in FIG. 4(b), the size in the horizontal direction of the burrs 208b produced on the bottom portion 111a of the cavity 111 was examined when producing a multi-layer ceramic substrate while setting, to various values, the margin M1 in the vertical direction and the margin M2 in the horizontal direction between the end portion of the groove 212 and the end portion of the thermal expansion layer 207.

A multi-layer ceramic substrate that includes a cavity having a 2.3 mm by 2.3 mm rectangular opening and has an electrode on the bottom portion of the cavity as shown in FIG. 8 (hereinafter, a "multi-layer ceramic substrate with an electrode") and a multi-layer ceramic substrate that includes a cavity having a 2.3 mm by 2.3 mm rectangular opening and has no electrode on the bottom portion of the cavity (hereinafter, a "multi-layer ceramic substrate without an electrode") were produced. The depths of the cavities were 200 $\mu$m and 300 $\mu$m. The results are shown in Tables 4 and 5. The margin M1 in the vertical direction and the margin M2 in the horizontal direction are as shown in Tables 4 and 5. The size of the burr 208b represents the sum of the lengths of the burrs 208b on the opposite sides for the width direction and for the longitudinal direction, and Tables 4 and 5 show an average value of the burrs 208b in the width direction and the longitudinal direction. The margin M1 being -50 indicates an over-cut, i.e., formation of a groove that is 50 $\mu$m

deeper than the thermal expansion layer. Such samples for the multi-layer ceramic substrate with an electrode were not produced because the electrode would then be severed.

[Table 4]

| Substrate type | | Multi-layer ceramic substrate with electrode | | Multi-layer ceramic substrate without electrode | |
|---|---|---|---|---|---|
| Margin M2 ($\mu$m) | | 75 | 50 | 75 | 50 |
| Margin M1 ($\mu$m) | 50 | 116 | 127 | 160 | 120 |
| | 25 | 74 | 70 | 155 | 106 |
| | 0 | 86 | 69 | 150 | 109 |
| | -50 | - | - | 120 | 111 |

[Table 5]

| Substrate type | | Multi-layer ceramic substrate with electrode | | Multi-layer ceramic substrate without electrode | |
|---|---|---|---|---|---|
| Margin M2 ($\mu$m) | | 75 | 50 | 75 | 50 |
| Margin M1 ($\mu$m) | 50 | 230 | 194 | 195 | 190 |
| | 40 | 136 | 160 | 154 | 151 |
| | 0 | 53 | 56 | 135 | 90 |
| | -50 | - | - | 160 | 126 |

It can be seen from the results of Table 4 and Table 5 that the burrs **208b** can generally be made smaller with a multi-layer ceramic substrate with an electrode. There is also a tendency that the burrs **208b** become longer as the cavity is deeper (Table 5). It can be seen from these results that it is possible to adjust the length of the burrs **208b** by varying the margins **M1** and **M2**. Specifically, it was found that it is possible to make the length of the burrs to be 250 $\mu$m or less by adjusting the margins **M1** and **M2,** and with a multi-layer ceramic substrate with an electrode, it is possible to make the length of the burrs **208b** to be about 100 $\mu$m or less by setting suitable margins **M1** and **M2.** Also, it was found that with a multi-layer ceramic substrate without an electrode, it is possible to make the length of the burrs **208b** to be about 150 $\mu$m or less by setting suitable margins **M1** and **M2.**

## INDUSTRIAL APPLICABILITY

The method of producing a multi-layer ceramic substrate of the present disclosure can suitably be used in a multi-layer ceramic substrate having a cavity that is suitable for various applications.

## REFERENCE SIGNS LIST

| | |
|---|---|
| 101: | Multi-layer ceramic substrate |
| 110: | Ceramic sinter |
| 110a: | Upper surface |
| 110b: | Lower surface |
| 111: | Cavity |
| 111a: | Bottom portion |
| 112, 113, 114, 115, 117: | Electrode |
| 118: | Passive element pattern |
| 119: | Wiring pattern |
| 120: | Conductive via |
| 151: | Semiconductor IC chip |

| 152: | Capacitor |
| 153: | Bonding wire |
| 200: | Ceramic green sheet |
| 201: | Via hole |
| 202: | Conductive paste |
| 203: | Wiring pattern |
| 204: | Passive element pattern |
| 206: | Region |
| 207: | Thermal expansion layer |
| 208: | Portion to be cavity |
| 208b: | Burrs |
| 205, 209, 210: | Electrode pattern |
| 212: | Groove |
| 250: | Carrier film |
| 260: | Second ceramic green sheet |
| 270: | First ceramic green sheet |

**Claims**

1. A method of producing a multi-layer ceramic substrate (101), the method comprising the steps of:

(A) preparing a first ceramic green sheet (270) with a thermal expansion layer (207) arranged thereon, and at least one second ceramic green sheet (260) with no thermal expansion layer arranged thereon, the thermal expansion layer being formed and patterned on the first ceramic green sheet by a printing method with use of a thermal expansion layer paste;
(B) laminating the first and second ceramic green sheets with the thermal expansion layer sandwiched therebetween, thereby obtaining a green sheet laminate (280);
(C) pressure-bonding together the first ceramic green sheet and the at least one second ceramic green sheet of the green sheet laminate;
(D) heating and thereby expanding the thermal expansion layer at least in a thickness direction in the pressure-bonded green sheet laminate;
(E) extracting a portion (208) of the green sheet laminate that has been displaced by the expansion of the thermal expansion layer, thereby forming a cavity (111) in the green sheet laminate; and
(F) sintering the green sheet laminate with the cavity formed therein.

2. The method of producing a multi-layer ceramic substrate according to claim 1, wherein in the step (D), the thermal expansion layer is held at a temperature higher than a temperature for pressure-bonding in the step (C).

3. The method of producing a multi-layer ceramic substrate according to claim 1 or 2, wherein the thermal expansion layer includes a thermal expansion material whose thickness increases by a factor of 2 or more by being heated.

4. The method of producing a multi-layer ceramic substrate according to any one of claims 1 to 3, wherein the thermal expansion layer is a layer of a paste including thermally-expansive microcapsules made of a thermoplastic resin that encapsulate a hydrocarbon that is in liquid form at normal temperature.

5. The method of producing a multi-layer ceramic substrate according to any one of claims 1 to 4, further comprising, between the step (C) and the step (D), a step of forming, in the green sheet laminate, a groove (212) that has a depth of the cavity of the green sheet laminate and defines an outline of the cavity.

6. The method of producing a multi-layer ceramic substrate according to any one of claims 1 to 5, wherein the thermal expansion layer is removed in the step (E).

7. The method of producing a multi-layer ceramic substrate according to any one of claims 1 to 6, wherein:

in the step (A),
a third ceramic green sheet (270') with another thermal expansion layer (207') arranged thereon is prepared in a region (206') different from the first ceramic green sheet;

in the step (B), the first to third ceramic green sheets are laminated together so that the thermal expansion layers are sandwiched therebetween, thereby obtaining the green sheet laminate;

in the step (D),

the other thermal expansion layer is heated to be expanded at least in the thickness direction; and

in the step (E),

a portion of the green sheet laminate that has been displaced by the expansion of the other thermal expansion layer is extracted.

8. The method of producing a multi-layer ceramic substrate according to any one of claims 1 to 7, further comprising, between the step (E) and the step (F), a step (G) of removing a binder from the green sheet laminate.

9. The method of producing a multi-layer ceramic substrate according to claim 8, wherein in the step (D), the thermal expansion layer is held at a temperature that is higher than a temperature for pressure-bonding in the step (C) and lower than a temperature for binder removing in the step (G).

10. The method of producing a multi-layer ceramic substrate according to any one of claims 1 to 9, wherein in the step (A), at least one of the first ceramic green sheet and the second ceramic green sheet includes a pattern to be internal wiring, an inductor, a condenser, a stripline or an internal resistor.

11. The method of producing a multi-layer ceramic substrate according to any one of claims 1 to 10, wherein in the step (A), the first ceramic green sheet further includes a conductor pattern located between the thermal expansion layer and the first ceramic green sheet.

12. The method of producing a multi-layer ceramic substrate according to any one of claims 1 to 11, wherein in the step (A), at least one of the first ceramic green sheet and the second ceramic green sheet further includes a via hole (201) and a conductive paste (202) that fills the via hole.

**Patentansprüche**

1. Verfahren zum Herstellen eines Mehrschicht-Keramiksubstrats (101), wobei das Verfahren die Schritte umfasst:

(A) Bereitstellen einer ersten keramischen Grünfolie (270) mit einer darauf angeordneten Wärmeausdehnungsschicht (207), sowie mindestens einer zweiten keramischen Grünfolie (260) ohne darauf angeordnete Wärmeausdehnungsschicht, wobei die Wärmeausdehnungsschicht durch ein Druckverfahren unter Verwendung einer Wärmeausdehnungsschichtpaste auf der ersten keramischen Grünfolie gebildet und strukturiert ist;

(B) Laminieren der ersten und der zweiten keramischen Grünfolie mit der Wärmeausdehnungsschicht sandwichartig dazwischen, wodurch ein Grünfolienlaminat (280) gewonnen wird;

(C) Druckverbinden der ersten keramischen Grünfolie und der mindestens einen zweiten keramischen Grünfolie des Grünfolienlaminats miteinander;

(D) Erhitzen und dadurch Ausdehnen der Wärmeausdehnungsschicht mindestens in einer Dickenrichtung in dem druckverbundenen Grünfolienlaminat;

(E) Herausnehmen eines Abschnitts (208) des Grünfolienlaminats, der durch die Ausdehnung der Wärmeausdehnungsschicht verdrängt wurde, wodurch ein Hohlraum (111) in dem Grünfolienlaminat gebildet wird; und

(F) Sintern des Grünfolienlaminats mit dem darin gebildeten Hohlraum.

2. Verfahren zum Herstellen eines Mehrschicht-Keramiksubstrats gemäß Anspruch 1, wobei in Schritt (D) die Wärmeausdehnungsschicht bei einer Temperatur gehalten ist, die höher als eine Temperatur zum Druckverbinden in Schritt (C) ist.

3. Verfahren zum Herstellen eines Mehrschicht-Keramiksubstrats gemäß Anspruch 1 oder 2, wobei die Wärmeausdehnungsschicht ein Wärmeausdehnungsmaterial aufweist, dessen Dicke sich durch Erhitzung um einen Faktor von 2 oder mehr vergrößert.

4. Verfahren zum Herstellen eines Mehrschicht-Keramiksubstrats gemäß einem der Ansprüche 1 bis 3, wobei die Wärmeausdehnungsschicht eine Schicht aus einer Paste ist, die aus einem thermoplastischen Harz hergestellte, wärmeausdehnende Mikrokapseln aufweist, welche einen Kohlenwasserstoff einkapseln, der bei normaler Temperatur flüssige Form hat.

**5.** Verfahren zum Herstellen eines Mehrschicht-Keramiksubstrats gemäß einem der Ansprüche 1 bis 4, das ferner zwischen dem Schritt (C) und dem Schritt (D) einen Schritt des Bildens einer Rille (212) in dem Grünfolienlaminat umfasst, die eine Tiefe des Hohlraums des Grünfolienlaminats hat und einen Umriss des Hohlraums definiert.

**6.** Verfahren zum Herstellen eines Mehrschicht-Keramiksubstrats gemäß einem der Ansprüche 1 bis 5, wobei die Wärmeausdehnungsschicht in Schritt (E) entfernt wird.

**7.** Verfahren zum Herstellen eines Mehrschicht-Keramiksubstrats gemäß einem der Ansprüche 1 bis 6, wobei:

in Schritt (A)
eine dritte keramische Grünfolie (270') mit einer darauf angeordneten weiteren Wärmeausdehnungsschicht (207') in einer Region (206'), die sich von der ersten keramischen Grünfolie unterscheidet, bereitgestellt wird;
in Schritt (B)
die erste bis dritte keramische Grünfolie so miteinander laminiert werden, dass die Wärmeausdehnungsschichten sandwichartig dazwischen liegen, wodurch ein Grünfolienlaminat gewonnen wird;
in Schritt (D)
die weitere Wärmeausdehnungsschicht erhitzt wird, um mindestens in der Dickenrichtung ausgedehnt zu werden; und
in Schritt (E)
ein Abschnitt des Grünfolienlaminats, der durch die Ausdehnung der anderen Wärmeausdehnungsschicht verdrängt wurde, herausgenommen wird.

**8.** Verfahren zum Herstellen eines Mehrschicht-Keramiksubstrats gemäß einem der Ansprüche 1 bis 7, das ferner zwischen dem Schritt (E) und dem Schritt (F) einen Schritt (G) des Entfernens eines Binders aus dem Grünfolienlaminat umfasst.

**9.** Verfahren zum Herstellen eines Mehrschicht-Keramiksubstrats gemäß Anspruch 8, wobei in Schritt (D) die Wärmeausdehnungsschicht bei einer Temperatur gehalten ist, die höher als eine Temperatur zum Druckverbinden in Schritt (C) und niedriger als eine Temperatur zur Binderentfernung in Schritt (G) ist.

**10.** Verfahren zum Herstellen eines Mehrschicht-Keramiksubstrats gemäß einem der Ansprüche 1 bis 9, wobei in Schritt (A) mindestens entweder die erste keramische Grünfolie oder die zweite keramische Grünfolie eine Struktur aufweist, die als interne Verdrahtung, ein Induktor, ein Kondensator, eine Streifenleitung oder ein interner Widerstand bestimmt ist.

**11.** Verfahren zum Herstellen eines Mehrschicht-Keramiksubstrats gemäß einem der Ansprüche 1 bis 10, wobei in Schritt (A) die erste keramische Grünfolie ferner eine Leiterstruktur aufweist, die zwischen der Wärmeausdehnungsschicht und der ersten keramischen Grünfolie liegt.

**12.** Verfahren zum Herstellen eines Mehrschicht-Keramiksubstrats gemäß einem der Ansprüche 1 bis 11, wobei in Schritt (A) mindestens entweder die erste keramische Grünfolie oder die zweite keramische Grünfolie ferner ein Verbindungsloch (201) und eine Leitpaste (202), die das Verbindungsloch füllt, aufweist.

## Revendications

**1.** Méthode de production d'un substrat céramique multicouches (101), la méthode comprenant les étapes de :

(A) préparation d'une première feuille verte céramique (270) avec une couche d'expansion thermique (207) agencée dessus, et au moins une seconde feuille verte céramique (260) sans couche d'expansion thermique agencée dessus, la couche d'expansion thermique étant formée et configurée sur la première feuille verte céramique par une méthode d'impression avec utilisation d'une pâte pour couche d'expansion thermique;
(B) laminage des première et seconde feuilles vertes céramiques avec la couche d'expansion thermique prise en sandwich entre elles, obtenant ainsi un laminé de feuilles vertes (280) ;
(C) collage sous pression ensemble de la première feuille verte céramique et d'au moins la seconde feuille verte céramique du laminé de feuilles vertes;
(D) chauffage et donc expansion de la couche d'expansion thermique au moins dans une direction d'épaisseur dans le laminé de feuilles vertes collé sous pression ;

(E) extraction d'une partie (208) du laminé de feuilles vertes qui a été déplacée par l'expansion de la couche d'expansion thermique, formant ici une cavité (111) dans le laminé de feuilles vertes; et
(F) frittage du laminé de feuilles vertes avec la cavité formée dedans.

2. Méthode de production d'un substrat céramique multicouches selon la revendication 1, dans laquelle à l'étape (D), la couche d'expansion thermique est maintenue à une température supérieure à une température en vue du collage sous pression à l'étape (C).

3. Méthode de production d'un substrat céramique multicouches selon les revendications 1 ou 2, dans laquelle la couche d'expansion thermique comporte un matériau d'expansion thermique dont l'épaisseur augmente d'un facteur de 2 ou plus en étant chauffée.

4. Méthode de production d'un substrat céramique multicouches selon une quelconque des revendications 1 à 3, dans laquelle la couche d'expansion thermique est une couche d'une pâte comportant des microcapsules expansives thermiquement fabriquées en résine thermoplastique qui encapsulent un hydrocarbure qui est sous forme liquide à température normale.

5. Méthode de production d'un substrat céramique multicouches selon une quelconque des revendications 1 à 4, comprenant par ailleurs, entre l'étape (C) et l'étape (D), une étape de formation, dans le laminé de feuilles vertes, d'une rainure (212) qui possède une profondeur de la cavité du laminé de feuilles vertes et définit un contour de la cavité.

6. Méthode de production d'un substrat céramique multicouches selon une quelconque des revendications 1 à 5, dans laquelle la couche d'expansion thermique est retirée à l'étape (E).

7. Méthode de production d'un substrat céramique multicouches selon une quelconque des revendications 1 à 6, dans laquelle :

   à l'étape (A),
   une troisième feuille verte céramique (270') avec une autre couche d'expansion thermique (207') agencée dessus est préparée dans une région (206') différente de la première feuille verte céramique;
   à l'étape (B), les première à troisième feuilles vertes céramiques sont laminées ensemble de sorte que les couches d'expansion thermique sont prises en sandwich entre elles, obtenant ainsi le laminé de feuilles vertes;
   à l'étape (D),
   l'autre couche d'expansion thermique est chauffée en vue d'être étendue dans la direction d'épaisseur; et
   à l'étape (E),
   une partie du laminé de feuilles vertes qui a été déplacé par l'expansion de l'autre couche d'expansion thermique est extraite.

8. Méthode de production d'un substrat céramique multicouches selon une quelconque des revendications 1 à 7, comprenant par ailleurs entre l'étape (E) et l'étape (F), une étape (G) de retrait d'un liant de la feuille de laminé verte.

9. Méthode de production d'un substrat céramique multicouches selon la revendication 8, dans laquelle à l'étape (D), la couche d'expansion thermique est maintenue à une température qui est supérieure à une température en vue du collage sous pression à l'étape (C) et inférieure à une température en vue du retrait du liant à l'étape (G).

10. Méthode de production d'un substrat céramique multicouches selon une quelconque des revendications 1 à 9, dans laquelle, à l'étape (A), au moins une de la première feuille céramique verte et de la seconde feuille céramique verte comporte un patron pour être câblée en interne, un inducteur, un condensateur, un strip-line ou une résistance interne.

11. Méthode de production d'un substrat céramique multicouches selon une quelconque des revendications 1 à 10, dans laquelle, à l'étape (A), la première feuille céramique verte comporte par ailleurs un patron conducteur situé entre la couche d'expansion thermique et la première feuille céramique verte.

12. Méthode de production d'un substrat céramique multicouches selon une quelconque des revendications 1 à 11, dans laquelle, à l'étape (A), au moins une de la première feuille céramique verte et de la seconde feuille céramique verte comporte par ailleurs un trou de passage (201) et une pâte conductrice (202) qui remplit le trou de passage.

*FIG.1*

(a)

(c)

(b)

*FIG.2*

S11 — FORM CERAMIC GREEN SHEET

S12 — FORM VIAS
IN CERAMIC GREEN SHEET

S13 — FILL VIAS WITH CONDUCTIVE
PASTE; FORM WIRING AND
PASSIVE ELEMENT PATTERNS

S14 — FORM THERMAL EXPANSION LAYER
ON CERAMIC GREEN SHEET

S15 — FORM FIRST AND SECOND
CERAMIC GREEN SHEETS

S16 — LAMINATE FIRST AND SECOND
CERAMIC GREEN SHEETS

S17 — FORM CIRCUIT PATTERN FOR
WIRING ON BOTTOM SURFACE

S18 — NON-PRELIMINARY
PRESSURE-BONDING

S19 — FORM GROOVE

S20 — HEAT THERMAL EXPANSION
LAYER

S21 — EXTRACT CAVITY

S22 — DEBINDER

S23 — CO-FIRE

*FIG.3*

(a)

(b)

(c)

*FIG.4*

## FIG.5

(a)

(b)

*FIG.6*

(a)

(b)

FIG.7

(a)

(b)

*FIG.8*

(a)

(b)

*FIG.9*

# FIG.10

(a)

(b)

## FIG.11

(a)

(b)

FIG.12

*FIG.13*

(a)

(b)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009188096 A
- JP 6215982 A

- JP 2001358247 A
- JP 2003273267 A